# EUROPÄISCHE PATENTSCHRIFT

(11) **EP 1 283 085 B1**
(45) Veröffentlichungstag und Bekanntmachung des Hinweises auf die Patenterteilung: **01.06.2005**
(21) Anmeldenummer: 02023748.3
(22) Anmeldetag: 20.11.1998
(51) Int. Cl.: B23K 1/005

(54) **Verfahren und Vorrichtung zur thermischen Verbindung von Anschlussflächen zweier Substrate**
Method and apparatus for thermal assembling of connecting areas of two substrates
Méthode et dispositif d'assemblage thermique de surfaces de connection de deux substrats

(30) Priorität: 20.11.1997 DE 19751487
(43) Veröffentlichungstag der Anmeldung: 12.02.2003
(62) Teilanmeldung aus: 98966159.0
(73) Patentinhaber: Pac Tech - Packaging Technologies GmbH, 14641 Nauen (DE)
(72) Erfinder: Momeni, Kaveh, Dr.-Ing., 10965 Berlin (DE)
(74) Vertreter: Tappe, Hartmut, Dipl.-Ing.

(56) Entgegenhaltungen:
- WO-A-91/06389
- WO-A-91/14529
- FR-A- 2 236 666
- US-A- 3 503 804
- US-A- 4 978 835
- PATENT ABSTRACTS OF JAPAN vol. 011, no. 255 (M-617), 19. August 1987 (1987-08-19) & JP 62 061789 A (FUJI ELECTRIC CO LTD), 18. März 1987 (1987-03-18)
- PATENT ABSTRACTS OF JAPAN vol. 011, no. 324 (P-628), 22. Oktober 1987 (1987-10-22) & JP 62 108224 A (INOUE JAPAX RES INC), 19. Mai 1987 (1987-05-19)

## Beschreibung

Die vorliegende Erfindung betrifft ein Verfahren zur thermischen Verbindung von in einer Überdeckungslage angeordneten Anschlussflächen zweier Substrate, wobei zumindest ein Substrat transparent ausgebildet ist und eine Beaufschlagung der Anschlussflächen mit Laserenergie von einer Rückseite des transparenten Substrats her erfolgt, wobei die Anschlussflächen der Substrate mittels einer auf die Substrate wirkenden Andruckeinrichtung gegeneinander gedrückt werden. Des weiteren betrifft die vorliegende Erfindung eine Vorrichtung zur Herstellung einer thermischen Verbindung von in einer Überdeckungslage angeordneten Anschlussflächen zweier Substrate gemäß dem Oberbegriff des Anspruchs 2.

Im vorliegenden Fall wird der Begriff Substrat so verstanden, dass hierunter sämtliche Bauelemente fallen, die mit einer Leiterbahnstruktur und äußeren Anschlussflächen zur Kontaktierung versehen sind; also beispielsweise Chips ebenso wie Leiterplatten. Ein bevorzugtes Anwendungsgebiet der hier vorgeschlagenen Verfahren bzw. Einsatzgebiet der hier vorgeschlagenen Vorrichtungen liegt in der Flip-Chip-Technologie sowie auch im Bereich der SMD(Surface Mounted Device)-Technologie.

Verfahren zur Verbindung bzw. Kontaktierung von in einer Überdeckungslage angeordneten Anschlussflächen zweier Substrate, bei denen Laserenergie zur Erzeugung der für die Verbindung notwendigen Wärme im Bereich der aus den Anschlussflächen gebildeten Kontaktpaarungen eingesetzt wird, sind bereits bekannt. So zeigt beispielsweise die DE 44 46 298 A1 ein Verfahren und eine Vorrichtung zur thermischen Verbindung von Anschlussflächen zweier Substrate, bei dem bzw. der zur Einleitung der Laserenergie in die Kontaktpaarungen der Anschlussflächen eine rückwärtige Energiebeaufschlagung durch ein transparentes Substrat erfolgt. Hierbei wird zur Ausbildung des Strahlengangs zwischen einer Laseremissionseinrichtung und dem rückwärtig zu beaufschlagenden Substrat eine Lichtleitfaser verwendet, die in ihrem Querschnitt so bemessen ist, dass eine gleichzeitige Beaufschlagung sämtlicher Kontaktpaarungen mit der aus dem Endquerschnitt der Lichtleitfaser emittierten Laserstrahlung möglich ist. Um das unter dem Begriff "self-alignment" bekannte Phänomen der sich infolge der Oberflächenspannung der aufgeschmolzenen Kontaktpaarungen ergebenden Änderungen der Relativposition der zu verbindenden Substrate ausnutzen zu können, liegen bei dem bekannten Verfahren die Anschlussflächen der Substrate ohne zusätzliche Druckbelastung, in ihrer Relativposition lediglich durch das Eigengewicht des oberen Substrats gesichert, gegeneinander an.

Bei dem aus der DE 44 46 289 A1 bekannten Verfahren wird die zur Herstellung der thermischen Verbindung zwischen den Anschlussflächen benötigte Wärmeenergie im wesentlichen durch eine Abstimmung der Transparenz des Substratmaterials und des Absorptionsvermögens des auf den Anschlussflächen angeordneten Verbindungsmaterials erreicht. Hieraus ergeben sich Einschränkungen bezüglich der freien Auswahl für das Substratmaterial und das Verbindungsmaterial.

Aus JP 4-91 493 A in: "Patent Abstracts of Japan", 1992 ist ein Verfahren bekannt, bei dem zur thermischen Verbindung von Anschlussflächen zweier Substrate eine rückwärtige Beaufschlagung eines transparenten Substrats durch eine transparente Druckplatte hindurch erfolgt, mit dem die Anschlussflächen der Substrate in Anlage gegeneinander gebracht werden. Als Druckplatte wird hierbei eine transparente Glasplatte verwendet. Die Laserenergiebeaufschlagung erfolgt bei diesem Verfahren abweichend von dem aus der DE 44 46 289 A1 bekannten Verfahren nicht für alle Kontaktpaarungen der Anschlussflächen gleichzeitig, sondern vielmehr sequentiell, wobei jeweils mehrere Kontaktpaarungen zu einer Einheit zusammengefasst sind, die einheitlich mit Laserenergie beaufschlagt wird.

Bei dem bekannten Verfahren ermöglicht die Verwendung der transparenten Glasplatte zwar die Übertragung eines Anpressdrucks auf die miteinander Kontaktpaarungen bildenden Anschlussflächen der Substrate. Jedoch kann es aufgrund von Fertigungsungenauigkeiten, die beispielsweise zu unterschiedlichen Höhen der auf den Anschlussflächen ausgebildeten Kontaktmetallisierungen führen können, dazu kommen, dass ein Teil der einander gegenüberliegenden Anschlussflächen keinen Berührungskontakt hat und so ein nur unzureichender thermischer Energieeintrag in die betreffenden Kontaktpaarungen erfolgt, was zu Kontaktfehlern mit der möglichen Folge eines Bauteilversagens im Betrieb der miteinander kontaktierten Substrate führen kann.

Aus der US-A-4,978,835 ist ein Verfahren zur thermischen Verbindung von in einer Überdeckungslage angeordneten Anschlussflächen zweier Substrate bekannt, bei dem zumindest ein Substrat transparent ausgebildet ist und eine Beaufschlagung der Anschlussflächen mit Laserenergie von einer Rückseite des transparenten Substrats her erfolgt, wobei die Anschlussflächen der Substrate mittels einer auf die Substrate wirkenden Andruckeinrichtung gegeneinander gedrückt werden.

Die US-A-4,978,835 zeigt auch eine Vorrichtung zur Herstellung einer thermischen Verbindung von in einer Überdeckungslage angeordneten Anschlussflächen zweier Substrate, wobei zumindest ein Substrat transparent ausgebildet ist und eine Beaufschlagung der Anschlussflächen mit Laserenergie von einer Rückseite des transparenten Substrats her erfolgt. Darüber hinaus weist die bekannte Vorrichtung eine Laseremissionseinrichtung zur Emission von Strahlungsenergie und eine Strahlungsübertragungseinrichtung zur Übertragung der Strahlungsenergie von der Laseremissionseinrichtung auf eine Kontaktpaarung von Anschlussflächen auf sowie eine auf die Substrate wirkende Andruckeinrichtung mit zumindest einer transparenten Krafteinleitungseinrichtung.

Der vorliegenden Erfindung liegt die Aufgabe zugrunde, ein Verfahren bzw. eine Vorrichtung vorzuschlagen, das bzw. die eine verbesserte Kontaktierung von Anschlussflächen zweier Substrate und damit eine erhöhte Zuverlässigkeit im Betrieb derartiger Substrate ermöglicht.

Diese Aufgabe wird durch ein Verfahren mit den Merkmalen des Anspruchs 1 gelöst.

Bei dem erfindungsgemäßen Verfahren nach Anspruch 1 werden die Anschlussflächen der Substrate mittels einer auf die Substrate wirkenden Andruckeinrichtung gegeneinander gedrückt, wobei zwischen einer transparenten Krafteinleitungseinrichtung der Andruckeinrichtung und einer Rückseite eines Substrats ein transparentes, inkompressibles und verformbares Volumen angeordnet ist. Dabei wirkt das vorgenannte Volumen aufgrund seiner Verformbarkeit wie ein Druckkissen, das eine flüssigkeitsdruckanaloge Druckbeaufschlagung des betreffenden Substrats ermöglicht. Hierdurch werden, anders als bei einer Druckbeaufschlagung, mittels einer starren Druckplatte Verformungen des Substrats möglich, die der Ausbildung von Spalten zwischen Anschlussflächen von Kontaktpaarungen entgegenwirken und so beispielsweise durch Fertigungsungenauigkeiten erzeugte Höhendifferenzen von auf den Anschlussflächen angeordneten Kontaktmetallisierungen ausgleichen können.

Eine zur Lösung der der Erfindung zugrunde liegenden Aufgabe geeignete Vorrichtung weist die Merkmale des Anspruchs 2 auf.

Bei der erfindungsgemäßen Vorrichtung ist eine auf die Substrate wirkende Andruckeinrichtung vorgesehen, die zumindest eine transparente Krafteinleitungseinrichtung aufweist, welche zumindest im Kontaktbereich zu einer Rückseite eines Substrats mit einem transparenten, inkompressiblen und verformbaren Volumen versehen ist. Hierdurch wird zwischen der Krafteinleitungseinrichtung und der Substratrückseite eine Art Druckkissen gebildet, das eine, wie vorstehend bereits ausgeführt wurde, flüssigkeitsdruckanaloge Beaufschlagung des Substrats mit entsprechender Substratverformung ermöglicht.

Als besonders vorteilhaft erweist es sich, wenn zur Ausbildung des transparenten, inkompressiblen und verformbaren Volumens die Krafteinleitungseinrichtung mit einer Lage aus Kunststoff belegt ist.

Um die Wirksamkeit des transparenten, inkompressiblen und verformbaren Volumens hinsichtlich einer flüssigkeitsdruckanalogen Beaufschlagung der Rückseite des Substrats zu erhöhen, kann das Volumen mit einer quer zur Andruckrichtung wirksamen Verformungsbegrenzungseinrichtung versehen sein.

Nachfolgend wird eine Ausführungsform einer erfindungsgemäßen Vorrichtung, die zur Durchführung einer Variante des erfindungsgemäßen Verfahrens geeignet ist, unter Bezugnahme auf die Zeichnungen näher erläutert. Es zeigen:
- **Fig. 1**: eine Vorrichtung zur thermischen Kontaktierung zweier in einer Andruckeinrichtung angeordneter Substrate, die sicht unter dem Schutzumfang der Ansprüche fällt.
- **Fig. 2**: eine Vorrichtung zur thermischen Kontaktierung zweier in einer Andruckeinrichtung angeordneter Substrate, die sicht unter dem Schutzumfang der Ansprüche fällt.
- **Fig. 3**: eine erfindungsgemäße Ausführungsform der in den **Fig. 1** und **2** dargestellten Andruckeinrichtung;

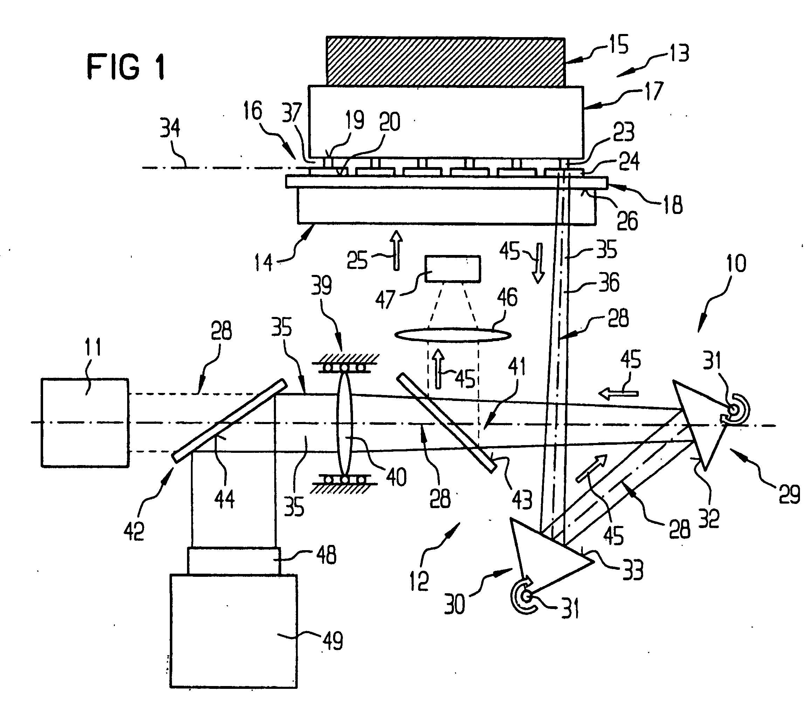

**Fig. 1** zeigt eine Laserverbindungsvorrichtung 10 mit einer Laseremissionseinrichtung 11, einer Strahlungsübertragungseinrichtung 12 und einer Substrataufnahmeeinrichtung 13. Die Substrataufnahmeeinrichtung 13 umfasst im vorliegenden Fall eine Andruckeinrichtung 14 und eine Gegenhalteeinrichtung 15.

Die Substrataufnahmeeinrichtung 13 dient zur Aufnahme einer Substratanordnung 16 aus zwei Substraten 17, 18, die mit einer hier nicht näher dargestellten Leiterbahnstruktur versehen sind und äußere Anschlüsse 19 bzw. 20 zur Kontaktierung aufweisen. Im vorliegenden Fall handelt es sich bei dem Substrat 17 um einen mit einer peripheren Anschlussflächenanordnung 21 versehenen Chip, dessen Anschlüsse 19 mit den Anschlüssen 20 des ebenfalls eine periphere Anschlussflächenanordnung 22 aufweisenden Substrats 18 kontaktiert werden sollen. Bei dem Substrat 18 handelt es sich im vorliegenden Fall um eine Trägerplatine, deren Anschlüsse 20 mit den Anschlüssen 19 verbunden werden sollen. Hierzu sind die Anschlüsse 19 und 20 mit erhöhten Kontaktmetallisierungen 23 bzw. 24 versehen, die das für eine thermische Verbindung benötigte Verbindungsmaterial bereitstellen.

Um für die nachfolgende thermisch bewirkte, stoffschlüssige Verbindung zwischen den Anschlussflächen 19 des Substrats 17 und den Anschlussflächen 20 des Substrats 18 einen möglichst spaltfreien Berührungskontakt herzustellen, ist die Andruckeinrichtung 14 in Richtung des Pfeils 25 gegen eine Rückseite 26 des unteren Substrats 18 bewegbar, wobei der notwendige Gegendruck durch die Gegenhalteeinrichtung 15 aufgebracht wird.

Die Gegenhalteeinrichtung 15 kann gleichzeitig als Handhabungseinrichtung ausgebildet sein, die dazu dient, das Substrat 17 aus einer hier nicht näher dargestellten Bereitstellungsposition in die in **Fig. 1** dargestellte Kontaktierungsposition zu überführen. Die hierzu notwendige Haftung zwischen dem Substrat 17 und der als Handhabungseinrichtung ausgeführten Gegenhalteeinrichtung 15 kann beispielsweise über einen zwischen der Gegenhalteeinrichtung 15 und dem Substrat 17 anliegenden Unterdruck erzeugt werden.

Die Andruckeinrichtung 14 sowie das auf der Andruckeinrichtung 14 angeordnete Substrat 18 weisen eine für die Wellenlänge einer aus der Laseremissionseinrichtung 11 emittierten Laserstrahlung 27 transparente Zusammensetzung auf.

Zwischen der Laseremissionseinrichtung 11 und der Substratanordnung 16 in der Substrataufnahmeeinrichtung 13 ist die Strahlungsübertragungseinrichtung 12 mit zwei Schwenkspiegeleinrichtungen 29 und 30 angeordnet. Wie aus **Fig. 1** deutlich wird, weisen die Schwenkspiegeleinrichtungen 29, 30 jeweils eine um eine quer zu einem Strahlengang 28 verlaufende Schwenkachse 31 und eine parallel zum Strahlengang verlaufende Schwenkachse 38 um zwei Raumachsen verschwenkbare Spiegelfläche 32 bzw. 33 auf. Durch die mittels der zwei Schwenkspiegeleinrichtungen 29, 30 bewirkte doppelte Umlenkung des Strahlengangs 28 wird ausgehend von einem im Wesentlichen parallel zu einer Verbindungsebene 34 der Substratanordnung 16 verlaufenden Strahlengangabschnitt 35 ein im Wesentlichen quer zur Verbindungsebene 34 verlaufender Strahlengangabschnitt 36 möglich. Dabei ermöglicht eine Schwenkbewegung der im Strahlengang 28 der ersten Schwenkspiegeleinrichtung 29 nachfolgend angeordneten zweiten Schwenkspiegeleinrichtung 30 bei entsprechender Winkelnachführung der ersten Schwenkspiegeleinrichtung 29 eine einander nachfolgende separate Beaufschlagung sämtlicher der aus jeweils zwei Anschlüssen 19 und 20 gebildeten Kontaktpaarungen 37 mit Laserenergie. Dabei können sowohl die Laseremissionseinrichtung 11 bzw. die in der Substrataufnahmeeinrichtung 13 angeordnete Substratanordnung 16 ihre Position unverändert beibehalten.

Aufgrund der transparenten Ausbildung der Andruckeinrichtung 14 sowie des Substrats 18 erfolgt die Beaufschlagung jeder Kontaktpaarung 37 durch die Andruckeinrichtung 14 und das Substrat 18 hindurch. Wegen des Strahlungsabsorptionsverhaltens der Anschlussflächen 20 kommt es zu einer Erwärmung und einem zumindest teilweisen Aufschmelzen der Kontaktmetallisierungen 23, 24 mit einer nachfolgenden stoffschlüssigen Verbindung zwischen den Anschlüssen 19 und 20.

Aus der in **Fig. 1** gewählten Darstellung, die als Beispiel für die einander nachfolgende Beaufschlagung sämtlicher Kontaktpaarungen 37 eine Laserenergiebeaufschlagung einer am rechten Rand der Substratanordnung 16 angeordneten Kontaktpaarung 37 zeigt, wird deutlich, dass eine bezogen auf den Abstand zwischen der Spiegelfläche 33 und der Kontaktpaarung 37 eingestellte Brennweite, die eine exakte Fokussierung der Laserstrahlung 27 auf die Kontaktpaarung 37 ermöglicht, beispielsweise bei einer Energiebeaufschlagung einer am linken Rand der Substratanordnung 16 angeordneten Kontaktpaarung 37 wegen des verlängerten Strahlengangabschnitts 36 angepasst werden muss. Hierzu ist im Strahlengangabschnitt 35 eine axial im Strahlengang verfahrbare Fokussierungseinrichtung 39 mit einer Sammellinse 40 vorgesehen.

Bei dem in **Fig. 1** dargestellten Beispiel der Laserverbindungsvorrichtung 10 sind in den Strahlengang 28 zwei Strahlungsauskopplungseinrichtungen 41 und 42 eingesetzt, die jeweils in Emissionsrichtung der Laseremissionseinrichtung 11 für die Laserstrahlung 27 durchlässig sind, jedoch von der jeweiligen Kontaktpaarung 37 emittierte bzw. reflektierte Strahlungsanteile entsprechend dem jeweils gewählten Anstellwinkel einer jeweiligen Spiegelfläche 43 bzw. 44 reflektieren. Die Strahlungsauskopplungseinrichtung 41 reflektiert, wie in **Fig. 1** dargestellt, über die Spiegelfläche 43 einen von der Kontaktpaarung 37 infolge deren Erwärmung emittierten Infrarot-Strahlungsanteil 45 nach vorheriger Bündelung durch eine Sammellinse 46 in einen Infrarot-Detektor 47. Die Strahlungsauskopplungseinrichtung 42 reflektiert den von der Kontaktpaarung 37 durch das transparente Substrat 18 und die transparente Andruckeinrichtung 14 reflektierten Anteil des im Strahlengang 28 vorhandenen sichtbaren Lichts über die Spiegelfläche 44 in eine Objektivlinse 48 einer Kameraeinrichtung 49 und ermöglicht somit mittels der Kameraeinrichtung 49 eine Überwachung der Kontaktpaarung 37.

In der in **Fig. 1** dargestellten Kombination mit der Fokussierungseinrichtung 39 eignet sich die Kameraeinrichtung 49 insbesondere im Zusammenwirken mit einer Bildverarbeitungseinrichtung zur Definition einer auf die Fokussierungseinrichtung 39 wirkenden Stellgröße nicht nur zu einer Überwachung der exakten Fokussierung der Laserstrahlung 27 auf die jeweilige Kontaktpaarung 37, sondern vielmehr auch zur Verstellung der Fokussierungseinrichtung. Basierend auf einer exakten Fokussierung der Laserstrahlung 27 auf die Kontaktpaarung 37 kann dann mittels des Infrarot-Detektors 47 eine Kontrolle der in der Kontaktpaarung 37 effektiven Laserleistung durchgeführt werden.

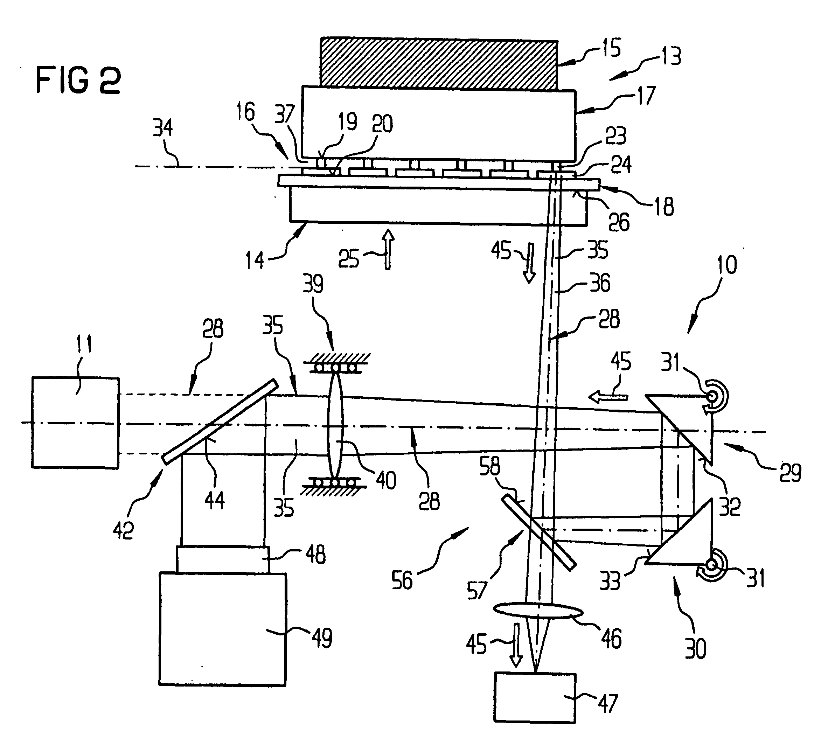

**Fig. 2** zeigt die Laserverbindungsvorrichtung 10 mit einer Strahlungsübertragungseinrichtung 56, die gegenüber der Strahlungsübertragungseinrichtung 12 **in Fig. 1** einen abweichenden Aufbau mit geänderter Anordnung des Infrarot-Detektors 47 aufweist. Ansonsten werden in der in **Fig. 2** dargestellten Laserverbindungsvorrichtung 10 entsprechend den identisch verwendeten Bezugszeichen auch identisch verwendete Komponenten eingesetzt. Wie aus einem Vergleich der **Fig. 1** und **2** deutlich wird, befinden sich die Schwenkspiegeleinrichtungen 29 und 30 in geänderter Relativanordnung, derart, dass die Schwenkspiegeleinrichtung 29 ihre Position beibehalten hat und die Schwenkspiegeleinrichtung 30 nunmehr unterhalb der Schwenkspiegeleinrichtung 29 angeordnet ist. Ferner ist anstatt der Strahlungsauskopplungseinrichtung 41 eine Strahlungsauskopplungseinrichtung 57 mit einer für Infrarot-Strahlung transparenten und für die Laserstrahlung 27 der Laseremissionseinrichtung 11 hoch reflektierenden Spiegelfläche 58 vorgesehen. Hierdurch wird es möglich, wie aus **Fig. 2** ersichtlich, den Infrarot-Detektor 47 ohne Strahlengangumlenkung direkt auf der optischen Achse der vom Anschluß 20 reflektierten Infrarot-Strahlung anzuordnen. Insgesamt wird durch die in **Fig. 2** dargestellte Anordnung eine genauere Erfassung des Infrarot-Strahlungsanteils 45 möglich.

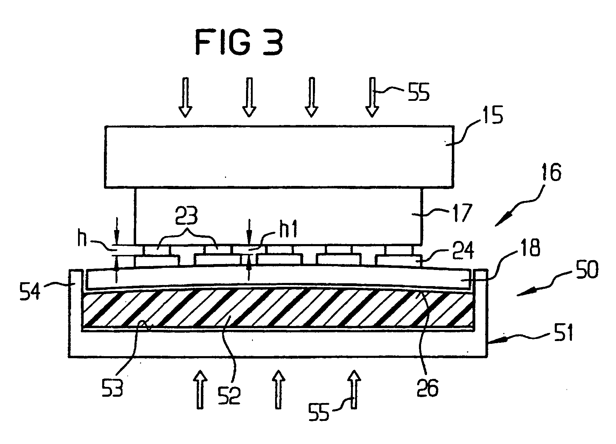

**Fig. 3** zeigt erfindungsgemäß Andruckeinrichtung 50 mit einer transparenten und starr ausgebildeten Krafteinleitungseinrichtung 51, die beispielsweise aus Glas oder einem transparenten Epoxydharz gebildet sein kann. Zwischen der Krafteinleitungseinrichtung 51 und der Rückseite 26 des Substrats 18 befindet sich ein transparentes, inkompressibles und darüber hinaus verformbares Volumen, das im vorliegenden Fall als Silikonkissen 52 ausgebildet ist. Das Silikonkissen 52 wird im vorliegenden Fall von einer Aufnahme 53 der Krafteinleitungseinrichtung 51 aufgenommen, wobei die Aufnahme 53 durch einen umlaufenden Randsteg 54 der Krafteinleitungseinrichtung 51 gebildet ist.

Bei einer durch die Kraftpfeile 55 angedeuteten Druckbeaufschlagung der Substratanordnung 16 durch die Krafteinleitungseinrichtung 51 zeigt das durch das Silikonkissen 52 gebildete, inkompressible und verformbare Volumen ein flüssigkeitsanaloges Druckverhalten, so dass beispielsweise Abweichungen in den Höhen h und h₁ der Kontaktmetallisierungen 23 des Substrats 17 durch eine entsprechende Verformung des Substrats 18 kompensiert werden. Dabei dient der Randsteg 54 als quer zur Druckrichtung wirkende Verformungsbegrenzung.

Wie **Fig. 3** zeigt, wird durch die Verwendung des Druckkissens 52 eine Ausbildung von Spalten zwischen den Kontaktmetallisierungen 23 und 24 der einander gegenüberliegend angeordneten Substrate 17 und 18 trotz Abweichungen in den Höhen h und h₁ der Kontaktmetallisierungen 23 verhindert. Aus dem Vorstehenden wird deutlich, dass die Anordnung eines transparenten, inkompressiblen und verformbaren Volumens in einer Andruckeinrichtung bei Durchführung einer Kontaktierung von einander gegenüberliegenden Anschlüssen zweier Substrate auch unabhängig von der Art der Beaufschlagung der Anschlussflächen mit Laserenergie, also sowohl bei separater als auch bei gemeinschaftlicher Beaufschlagung der Anschlussflächen mit Laserenergie, wirksam die Qualität der Kontaktierung verbessert, da in jedem Fall einer Spaltausbildung zwischen den Anschlüssen entgegengewirkt wird.

Die anhand der vorstehenden Ausführungsbeispiele beschriebenen Verfahrensvarianten sowie die dabei eingesetzten Vorrichtungen lassen sich unter anderem vorteilhaft bei der Herstellung von Chipkarten sowie der Herstellung von gehäusten, insbesondere nach der "Chip Scale Packaging"-Technologie hergestellten Chipmodulen verwenden. Unabhängig von der jeweiligen Verfahrensvariante oder dem jeweiligen Ausführungsbeispiel der Vorrichtung lassen sich auch Verbindungen eines insbesondere als Chip 59 ausgebildeten Substrats mit einem Trägersubstrat 60 herstellen, wie in **Fig. 4** dargestellt.

## Patentansprüche

1. Verfahren zur thermischen Verbindung von in einer Überdeckungslage angeordneten Anschlussflächen zweier Substrate einer Substratanordnung, wobei zumindest ein Substrat transparent ausgebildet ist, und eine Beaufschlagung der Anschlussflächen mit Laserenergie von einer Rückseite des transparenten Substrats her erfolgt, wobei die Anschlussflächen der Substrate mittels einer auf die Substrate wirkenden Andruckeinrichtung gegeneinander gedrückt werden,
**dadurch gekennzeichnet,**
**dass** zwischen einer transparenten Krafteinleitungseinrichtung (51) der Andruckeinrichtung und einer Rückseite (26) eines Substrats (18) ein transparentes, inkompressibles und verformbares Volumen (52) angeordnet ist, derart, dass bei einer Druckbeaufschlagung der Substratanordnung die Krafteinleitungseinrichtung ein flüssigkeitsanaloges Druckverhalten zeigt.

2. Vorrichtung zur Herstellung einer thermischen Verbindung von in einer Überdeckungslage angeordneten Anschlussflächen zweier Substrate einer Substratanordnung, wobei zumindest ein Substrat transparent ausgebildet ist und eine Beaufschlagung der Anschlussflächen mit Laserenergie von einer Rückseite des transparenten Substrats her erfolgt, aufweisend
eine Laseremissionseinrichtung zur Emission von Strahlungsenergie,
eine Strahlungsübertragungseinrichtung zur Übertragung der Strahlungsenergie von der Laseremissionseinrichtung auf eine Kontaktpaarung von Anschlussflächen, und
eine auf die Substrate wirkende Andruckeinrichtung mit zumindest einer transparenten Krafteinleitungseinrichtung,
**dadurch gekennzeichnet,**
**dass** die Krafteinleitungseinrichtung zumindest im Kontaktbereich zur Rückseite (26) des Substrats (18) mit einem transparenten, inkompressiblen und verformbaren Volumen (52) versehen ist, das bei einer Druckbeaufschlagung der Substratanordnung ein flüssigkeitsanaloges Druckverhalten zeigt.

3. Vorrichtung nach Anspruch 2,
**dadurch gekennzeichnet,**
**dass** zur Ausbildung des transparenten, inkompressiblen, im Wesentlichen flüssigkeitsanalog wirkenden, verformbaren Volumens (52) die Krafteinleitungseinrichtung (51) mit einer Lage aus Kunststoff belegt ist.

4. Vorrichtung nach Anspruch 2 oder 3,
**dadurch gekennzeichnet,**
**dass** das Volumen (52) quer zur Andruckeinrichtung (50) mit einer Verformungsbegrenzungseinrichtung (54) versehen ist.

## Claims

1. Method for the thermal connection of connecting surfaces, arranged in an overlapping configuration, of two substrates of a substrate arrangement, in which at least one substrate is transparent and laser energy is applied to the connecting surfaces from a rear side of the transparent substrate, wherein the connecting surfaces of the substrates are pressed against one another by means of a pressing device acting on the substrates, **characterised in that** a transparent, incompressible and deformable space (52) is arranged between a transparent power input device (51) of the pressing device and a rear side (26) of a substrate (18) in such a way that the power input device exhibits a pressure behaviour similar to a liquid when the substrate arrangement is subjected to pressure.

2. Apparatus for forming a thermal connection of connecting surfaces, arranged in an overlapping configuration, of two substrates of a substrate arrangement, in which at least one substrate is transparent and laser energy is applied to the connecting surfaces from a rear side of the transparent substrate, said apparatus comprising a laser emitting device for emitting radiation energy, a radiation transmitting device for transmitting the radiation energy from the laser emitting device to a contact pair of connecting surfaces, and a pressing device with at least one transparent power input device acting on the substrates, **characterised in that** the power input device is provided, at least in the contact region with the rear side (26) of the substrate (18), with a transparent, incompressible and deformable space (52) that exhibits a pressure behaviour similar to a liquid when the substrate arrangement is subjected to pressure.

3. Apparatus according to claim 2, **characterised in that** to form the transparent, incompressible, deformable space (52) acting substantially similarly to a liquid, the power input device (51) is covered with a layer of plastics material.

4. Apparatus according to claim 2 or 3, **characterised in that** the space (52) is provided, transverse to the pressing device (50), with a deformation limiting device (54).

## Revendications

1. Procédé pour la liaison thermique de surfaces de raccordement de deux substrats d'une disposition de substrats, les surfaces de raccordement étant disposées dans une couche de recouvrement, au moins un substrat étant formé de façon transparente, et un impact d'énergie laser se réalisant sur les surfaces de raccordement à partir d'un côté arrière du substrat transparent, les surfaces de raccordement des substrats étant pressées l'une contre l'autre au moyen d'un dispositif de compression agissant sur les substrats,
**caractérisé en ce que**,
un volume (52) transparent, incompressible et déformable, est disposé entre un dispositif transparent (51) induisant une force du dispositif de compression, et un côté arrière (26) d'un substrat (18), de sorte que, lors d'un impact compressif sur la disposition de substrats, le dispositif induisant une force présente un comportement en compression analogue à celui d'un liquide.

2. Dispositif pour préparer une liaison thermique de surfaces de raccordement de deux substrats d'une disposition de substrats, les surfaces de raccordement étant disposées dans une couche de recouvrement, au moins un substrat étant formé de façon transparente et un impact d'énergie laser se réalisant sur les surfaces de raccordement à partir d'un côté arrière du substrat transparent, présentant un dispositif d'émission laser pour émettre de l'énergie de rayonnement, un dispositif de transmission de rayonnement pour transmettre l'énergie de rayonnement à partir du dispositif d'émission laser sur un appariement de contact de surfaces de raccordement, et un dispositif de compression agissant sur les substrats avec au moins un dispositif transparent induisant une force,
**caractérisé en ce que**,
le dispositif induisant une force est muni au moins dans la zone de contact avec le côté arrière (26) du substrat (8) d'un volume (52) transparent, incompressible et déformable, qui, lors d'un impact compressif sur la disposition de substrats, présente un comportement en compression analogue à celui d'un liquide.

3. Dispositif selon la revendication 2,
**caractérisé en ce que**,
pour former le volume (52) transparent, incompressible, agissant essentiellement de façon analogue à un liquide, déformable, le dispositif induisant une force (51) est occupé par une couche de matière plastique.

4. Dispositif selon la revendication 2 ou 3,
**caractérisé en ce que**,
le volume (52) est muni d'un dispositif (54) limitant la déformation, transversalement au dispositif de compression (50).
